# EUROPÄISCHE PATENTSCHRIFT

(11) **EP 1 134 590 B1**
(45) Veröffentlichungstag und Bekanntmachung des Hinweises auf die Patenterteilung: **16.04.2008**
(21) Anmeldenummer: 01250081.5
(22) Anmeldetag: 13.03.2001
(51) Int. Cl.: G01R 31/02

(54) **Elektrische Schaltungsanordnung zur Überprüfung von Leitungen und elektrischen Komponenten**
Electrical device for testing lines and electrical components
Dispositif électrique pour la vérification des lignes et composants électriques

(30) Priorität: 16.03.2000 DE 10014434
(43) Veröffentlichungstag der Anmeldung: 19.09.2001
(73) Patentinhaber: Volkswagen AG, 38436 Wolfsburg (DE)
(72) Erfinder: Lübke, Andreas, Dipl. Ing., 38442 Wolfsburg (DE); Stock, Friedrich, Dipl. Ing., 38442 Wolfsburg (DE); Van Gerpen, Dieter, Dipl. Ing., 38154 Königslutter (DE)
(74) Vertreter: Patentanwälte Bressel und Partner

(56) Entgegenhaltungen:
- PATENT ABSTRACTS OF JAPAN vol. 007, no. 109 (P-196), 12. Mai 1983 (1983-05-12) & JP 58 030674 A (HITACHI SEISAKUSHO KK), 23. Februar 1983 (1983-02-23)
- PATENT ABSTRACTS OF JAPAN vol. 014, no. 269 (P-1059), 11. Juni 1990 (1990-06-11) & JP 02 077666 A (HITACHI LTD), 16. März 1990 (1990-03-16)

## Beschreibung

Die Erfindung betrifft eine elektrische Schaltungsanordnung zur Überprüfung von Leitungen und elektrischen Komponenten gemäß dem Oberbegriff des Anspruchs 1.

Insbesondere bei der Installation von elektrischen Schaltungsanordnungen muss die Funktionalität der elektrischen Komponente und deren Zuleitungen und Verbindungen überprüft werden. Dies erfolgt beispielsweise durch einen Funktionstest. Ist die elektrische Komponente beispielsweise eine Glühleuchte, so wird diese in Betrieb genommen. Brennt die Glühleuchte, so lässt dies auf eine fehlerfreie Installation schließen. Brennt die Lampe hingegen nicht, so lässt dies auf einen Fehler schließen, die Fehlerursache hingegen bleibt unbekannt, so dass gegebenenfalls größere Untersuchungen nach der Ursache folgen müssen. Die gleichen Überlegungen gelten für die Betriebsphase oder bei Reparatur und Service.

Aus der JP 02/077 666 A ist ein Verfahren zur Überprüfung der Verdrahtung zweier Netzwerke bekannt, wobei durch eine Bestimmung des Widerstandes ein Kurzschluss zwischen den Nutzern ermittelt wird, da dann die Abschlusswiderstände des einen Nutzers parallel zu den Abschlusswiderständen des anderen Nutzers geschaltet sind.

Aus der JP 58 030 67 4 ist ein Kabeltester bekannt, bei dem die einzelnen Adern an einem Ende des Kabels einerseits auf Massepotential gelegt werden können und an dem anderen Ende über Schalter mit verschiedenen Widerständen verbunden werden, so dass über resultierende Widerstände Kurzschlüsse und Unterbrechungen der Adern ermittelt werden können.

Der Erfindung liegt daher das technische Problem zugrunde, eine elektrische Schaltungsanordnung zu schaffen, mittels derer qualitative Aussagen über Fehlerursachen möglich sind.

Die Lösung des technischen Problems ergibt sich durch den Gegenstand mit den Merkmalen des Patentanspruchs 1. Weitere vorteilhafte Ausgestaltungen der Erfindung ergeben sich aus den Unteransprüchen.

Hierzu ist die elektrische Schaltungsanordnung zur Überprüfung von Leitungen und elektrischen Komponenten, bei der mindestens eine zu überprüfende elektrische Komponente über eine Leitung mit einem Schaltelement verbunden ist, über das die Schaltungsanordnung mit einer elektrischen Spannungsversorgung verbunden ist, derart ausgebildet, dass parallel zur zu überprüfenden elektrischen Komponente ein Abschlusswiderstand angeordnet ist und der Leitung mehrere, entlang der Leitung verteilte Abschlusswiderstände zugeordnet sind, die parallel zum Abschlusswiderstand der zu überprüfenden elektrischen Komponente angeordnet sind, wobei die Schaltungsanordnung eine Einrichtung zur Erfassung des Eingangswiderstandes der Schaltungsanordnung umfasst, wobei der Abschlusswiderstand der zu überprüfenden elektrischen Komponente und die Abschlusswiderstände der Leitung ein Vielfaches größer als der Innenwiderstand der zu überprüfenden elektrischen Komponente sind.

In einer bevorzugten Ausführungsform ist der Abschlusswiderstand um ein Vielfaches größer als der Innenwiderstand der elektrischen Komponente, um die elektrischen Verluste aufgrund des zusätzlichen Abschlusswiderstandes gering zu halten.

In einer bevorzugten Ausführungsform sind der Abschlusswiderstand und die elektrische Komponente in einer gemeinsamen Steckverbindung angeordnet.

Sind zwischen der elektrischen Komponente und dem Schaltelement Inline-Stecker angeordnet, so werden diese ebenfalls jeweils mit einem Abschlusswiderstand ausgebildet, der vorzugsweise ein Vielfaches größer als der Innenwiderstand der zu überprüfenden elektrischen Komponente ist.

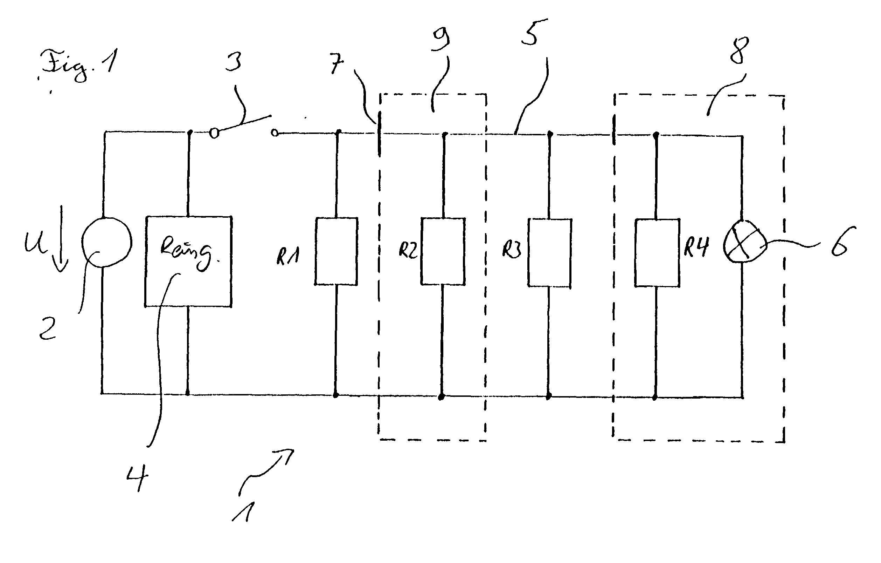

Die Erfindung wird nachfolgend anhand eines bevorzugten Ausführungsbeispieles näher erläutert. Die einzige Figur zeigt eine Schaltungsanordnung zur Überprüfung von Leitungen und elektrischen Komponenten.

Die Schaltungsanordnung 1 umfasst ein Schaltelement 3, eine Einrichtung 4 zur Erfassung des Eingangswiderstandes, eine Leitung 5, eine elektrische Komponente 6, einen Inline-Stecker 7 und Abschlusswiderstände R1- R4. Dabei ist der Abschlusswiderstand R4 der elektrischen Komponente 6 zugeordnet und mit dieser in einer gemeinsamen Steckverbindung 8 angeordnet. Der Abschlusswiderstand R2 ist in dem Inline-Stecker 7 angeordnet und bildet mit diesem eine Steckeinheit 9. Die Abschlusswiderstände R1 und R3 sind der Leitung 5 zugeordnet. Dabei gilt, dass die Abschlusswiderstände R1- R4 um ein Vielfaches hochohmiger als der Innenwiderstand Rᵢₙ der elektrischen Komponente 6 sind. Über das Schaltelement 3 ist die Schaltungsanordnung 1 mit einer Spannungsquelle 2 verbunden.

Zur Erläuterung der prinzipiellen Wirkungsweise sollen zunächst die Abschlusswiderstände R1 und R3 vernachlässigt werden. Zur Überprüfung der Leitung 5 und der elektrischen Komponente 6 wird zunächst das Schaltelement 3 geschlossen und durch die Einrichtung 4 zur Erfassung des Eingangswiderstandes wird der Eingangswiderstand Rₑᵢₙ der Schaltungsanordnung bestimmt. Durch Auswertung von Rₑᵢₙ kann dann auf den Zustand der Schaltungsanordnung zurückgeschlossen werden. Bei einem Kurzschluß der Leitung 5 wird ein Eingangswiderstand Rₑᵢₙ≈ 0 erfaßt. Da der Eigenwiderstand der Leitung 5 vernachlässigbar klein ist, ist eine genaue Lokalisierung des Kurzschlusses sehr schwierig. Bei einem Leitungsbruch vor dem Inline- Stecker 7 bzw. bei nicht gestecktem Inline- Stecker 7 würde ein Eingangswiderstand Rₑᵢₙ≈ ∞ erfaßt werden bzw. bei Berücksichtigung von R1 Rₑᵢₙ≈ R1. Bei einem Leitungsbruch nach dem Inline- Stecker 7 und vor der Steckverbindung 8 wird hingegen ein Eingangswiderstand Rₑᵢₙ≈ R2 erfaßt. Unter Berücksichtigung der Abschlußwiderstände R1 und R3 setzt sich der Eingangswiderstand Rₑᵢₙ aus der Parallelschaltung von R1 und R2 bzw. R1, R2 und R3 zusammen, je nachdem, ob der Leitungsbruch vor oder hinter dem Abschlußwiderstand R3 liegt. Mittels der der Leitung 5 zugeordneten Abschlußwiderstände R1 und R3 läßt sich somit der Ort der Leitungsunterbrechung genauer lokalisieren. Eine nicht gesteckte Steckverbindung 8 ergibt den gleichen Eingangswiderstand Rₑᵢₙ wie eine Leitungsunterbrechung hinter R3. Bei einer defekten elektrischen Komponente 6 bzw. einer fehlenden elektrischen Komponente 6 ergibt sich der Eingangswiderstand Rₑᵢₙ als Parallelschaltung aller Abschlußwiderstände R1- R4. Ist hingegen die elektrische Komponente 6 vorhanden und betriebsbereit, so setzt sich der Eingangswiderstand Rₑᵢₙ aus der Paralleischaltung der Abschlußwiderstände R1- R4 und Rᵢₙ zusammen. Unter der Voraussetzung, daß die Abschlußwiderstände R1- R4 um ein Vielfaches größer als der Innenwiderstand Rᵢₙ der elektrischen Komponente 6 ist, ist der erfaßte Eingangswiderstand Rₑᵢₙ≈ Rᵢₙ.

Mittels der Schaltungsanordnung 1 ist somit eine Fehlerdiagnose mit Lokalisierung möglich, die dann angezeigt werden kann. Bei einem erfaßten Kurzschluß kann zusätzlich das Schaltelement 3 geöffnet werden.

## Patentansprüche

1. Elektrische Schaltungsanordnung (1) zur Überprüfung von Leitungen (5) und elektrischen Komponenten (6), bei der mindestens eine zu überprüfende elektrische Komponente (6) über eine Leitung (5) mit einem Schaltelement (3) verbunden ist, über das die Schaltungsanordnung mit einer elektrischen Spannungsversorgung verbunden ist,
**dadurch gekennzeichnet, dass**
parallel zur zu überprüfenden elektrischen Komponente (6) ein Abschlusswiderstand (R4) angeordnet ist und der Leitung (5) mehrere, entlang der Leitung (5) verteilte Abschlusswiderstände (R1, R3) zugeordnet sind, die parallel zum Abschlusswiderstand (R4) der zu überprüfenden elektrischen Komponente (6) angeordnet sind, wobei die Schaltungsanordnung (1) eine Einrichtung (4) zur Erfassung des Eingangswiderstandes (Rₑᵢₙ) der Schaltungsanordnung (1) umfasst, wobei der Abschlusswiderstand (R4) der zu überprüfenden elektrischen Komponente (6) und die Abschlusswiderstände (R3, R1) der Leitung (5) ein Vielfaches größer als der Innenwiderstand (Rᵢₙ) der zu überprüfenden elektrischen Komponente (6) sind.

2. Elektrische Schaltungsanordnung nach Anspruch 1, **dadurch gekennzeichnet, dass** der Abschlusswiderstand (R4) der zu überprüfenden elektrischen Komponente (6) und die zu überprüfende elektrische Komponente (6) in einer gemeinsamen Steckverbindung (8) angeordnet sind.

3. Elektrische Schaltungsanordnung nach einem der vorangegangenen Ansprüche, **dadurch gekennzeichnet, dass** zwischen der zu überprüfenden elektrischen Komponente (6) und dem Schaltelement (3) mindestens ein Inline-Stecker (7) angeordnet ist, in dem jeweils ein weiterer Abschlusswiderstand (R2) angeordnet ist.

4. Elektrische Schaltungsanordnung nach Anspruch 3, **dadurch gekennzeichnet, dass** der Abschlusswiderstand (R2) jedes Inline-Steckers (7) ein Vielfaches größer als der Innenwiderstand (Rᵢₙ) der zu überprüfenden elektrischen Komponente (6) ist.

## Claims

1. Electrical circuit arrangement (1) for testing lines (5) and electrical components (6), in which arrangement at least one electrical component (6) to be tested is connected to a switching element (3) via a line (5), and the circuit arrangement is connected to an electrical voltage supply via the said switching element,
**characterized in that**
a terminating resistor (R4) is arranged in parallel with the electrical component (6) to be tested and a plurality of terminating resistors (R1, R3), which are distributed along the line (5) and are arranged in parallel with the terminating resistor (R4) of the electrical component (6) to be tested, are associated with the line (5), with the circuit arrangement (1) comprising a device (4) for detecting the input resistance (Rᵢₙ) of the circuit arrangement (1), with the terminating resistance (R4) of the electrical component (6) to be tested and the terminating resistances (R3, R1) of the line (5) being several times greater than the internal resistance (Rᵢₙ) of the electrical component (6) to be tested.

2. Electrical circuit arrangement according to Claim 1, **characterized in that** the terminating resistor (R4) of the electrical component (6) to be tested and the electrical component (6) to be tested are arranged in a common plug connection (8).

3. Electrical circuit arrangement according to either of the preceding claims, **characterized in that** at least one inline connector (7), in which a further terminating resistor (R2) is arranged in each case, is arranged between the electrical component (6) to be tested and the switching element (3).

4. Electrical circuit arrangement according to Claim 3, **characterized in that** the terminating resistance (R2) of each inline connector (7) is several times greater than the internal resistance (Rᵢₙ) of the electrical component (6) to be tested.

## Revendications

1. Arrangement de circuit électrique (1) destiné à contrôler des câbles (5) et des composants électriques (6), avec lequel au moins un composant électrique (6) à contrôler est relié par le biais d'un câble (5) avec un élément de commutation (3) par le biais duquel l'arrangement de circuit est relié avec une source d'alimentation électrique, **caractérisé en ce qu'**une résistance de terminaison (R4) est branchée en parallèle avec le composant électrique (6) à contrôler et plusieurs résistances de terminaison (R1, R3) réparties le long du câble (5) sont associées au câble (5), lesquelles sont branchées en parallèle à la résistance de terminaison (R4) du composant électrique (6) à contrôler, l'arrangement de circuit (1) comprenant un dispositif (4) pour détecter la résistance d'entrée (Rₑᵢₙ) de l'arrangement de circuit (1), la résistance de terminaison (R4) du composant électrique (6) à contrôler et les résistances de terminaison (R1, R3) du câble (5) étant considérablement supérieures à la résistance interne (Rᵢₙ) du composant électrique (6) à contrôler.

2. Arrangement de circuit électrique selon la revendication 1, **caractérisé en ce que** la résistance de terminaison (R4) du composant électrique (6) à contrôler ainsi que le composant électrique (6) à contrôler sont disposés dans un connecteur (8) commun.

3. Arrangement de circuit électrique selon l'une des revendications précédentes, **caractérisé en ce qu'**entre le composant électrique (6) à contrôler et l'élément de commutation (3) est disposé au moins un connecteur en ligne (7) dans lequel est à chaque fois disposée une résistance de terminaison (R2) supplémentaire.

4. Arrangement de circuit électrique selon la revendication 3, **caractérisé en ce que** la résistance de terminaison (R2) de chaque connecteur en ligne (7) est considérablement supérieure à la résistance interne (Rᵢₙ) du composant électrique (6) à contrôler.
